# EUROPÄISCHE PATENTSCHRIFT

(11) **EP 2 856 037 B1**
(45) Veröffentlichungstag und Bekanntmachung des Hinweises auf die Patenterteilung: **14.12.2016**
(21) Anmeldenummer: 13734852.0
(22) Anmeldetag: 23.05.2013
(51) Int. Cl.: F24C 7/08, H03K 17/96

(54) **HAUSGERÄTEBEDIENVORRICHTUNG**
HOUSEHOLD APPLIANCE OPERATING DEVICE
DISPOSITIF DE COMMANDE D'APPAREIL MÉNAGER

(30) Priorität: 30.05.2012 ES 201230822
(43) Veröffentlichungstag der Anmeldung: 08.04.2015
(73) Patentinhaber: BSH Hausgeräte GmbH, 81739 München (DE)
(72) Erfinder: ALAMAN AGUILAR, Jorge, E-50008 Zaragoza (ES); ESTER SOLA, Francisco, Javier, E-50001 Zaragoza (ES); HERNANDEZ BLASCO, Pablo Jesus, E-50410 Cuarte de Huerva (Zaragoza) (ES); PLANAS LAYUNTA, Fernando, E-50009 Zaragoza (ES)
(86) Internationale Anmeldenummer: PCT/IB2013/054273
(87) Internationale Veröffentlichungsnummer: WO 2013/179193

(56) Entgegenhaltungen:
- EP-A2- 1 505 350
- WO-A1-2012/032432
- DE-A1- 4 207 772
- DE-A1-102009 000 653
- DE-A1-102009 017 419

## Beschreibung

Es sind Kochfelder bekannt, welche ein spezielles Touch-Bedienelement zur Verriegelung und Entriegelung des Kochfelds aufweisen. Wurde das Kochfeld durch das Touch-Bedienelement verriegelt, sind sämtliche weitere Touch-Bedienelemente des Kochfelds gesperrt, so dass ein versehentliches oder unbefugtes Einschalten, insbesondere durch Kinder, verhindert ist. Wurde das Kochfeld durch das Touch-Bedienelement entriegelt, ist eine normale Verwendung der weiteren Touch-Bedienelemente möglich. Zu einer Herstellung eines verriegelten Zustands ist somit ein spezieller Bedieneingriff eines Bedieners nötig, welcher insbesondere auch durch ein Kind getätigt werden könnte.

Ferner sind weitere Kochfelder mit kapazitiven Touch-Bedienelementen bekannt, welche über eine spezielle Software und/oder Hardware ermitteln, ob eine Betätigung des jeweiligen Touch-Bedienelements durch einen Erwachsenen oder ein Kind erfolgte. Hierbei wird die Tatsache ausgenutzt, dass ein Erwachsenenfinger in der Regel einen größeren Durchmesser als ein Kinderfinger aufweist und somit eine Beeinflussung eines elektrischen Felds, welches von einer Elektrode des jeweiligen Touch-Bedienelements ausgeht, bei einer Annäherung des Erwachsenfingers stärker ausfällt als bei einer Annäherung des Kinderfingers.

EP 1 505 350 A2 offenbart beispielsweise eine derartige Hausgerätebedienvorrichtung mit einer Bedienoberfläche, welche mehrere Bedienflächen aufweist, wobei die einer der Bedienflächen zugeordnete Funktion nur dann ausgelöst wird, wenn ein durch eine Sensoreinheit detektierter Finger eine vorgebbare oder vorgegebene Kontur aufweist. Hierbei wird eine Betätigung der Bedienflächen durch ein Kind verhindert.

Des Weiteren offenbart WO 2012/032432 A1 eine Hausgerätebedienvorrichtung mit einer Touch-Sensoreinheit, mit einer der Touch-Sensoreinheit zugeordneten Elektrode wobei die Elektrode zumindest einen Sensorbereich umfasst.

Die Aufgabe der Erfindung besteht insbesondere darin, eine vorteilhafte Sicherung für Touch-Bedienelemente eines Hausgeräts gegen eine unbefugte Benutzung bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Es wird eine Hausgerätebedienvorrichtung, insbesondere eine Kochfeldbedienvorrichtung, vorgeschlagen mit wenigstens einer Touch-Sensoreinheit, mit zumindest einer der Touch-Sensoreinheit zugeordneten Elektrode, welche zumindest einen ersten Sensorbereich und zumindest einen elektrisch leitend mit dem ersten Sensorbereich verbundenen zweiten Sensorbereich umfasst, welche dazu vorgesehen sind, die Touch-Sensoreinheit lediglich bei einer gemeinsamen Annäherung und/oder Berührung durch einen Bediener auszulösen, und mit wenigstens einem von der Elektrode verschieden ausgebildeten Bereich, welcher zwischen dem ersten Sensorbereich und dem zweiten Sensorbereich angeordnet ist und welcher entlang wenigstens einer Verbindungsstrecke von dem ersten Sensorbereich zu dem zweiten Sensorbereich eine Erstreckung von zumindest 5 mm, insbesondere von wenigstens 7,5 mm, vorzugsweise von mindestens 10 mm, vorteilhaft von zumindest 12,5 mm und besonders vorteilhaft von wenigstens 15 mm aufweist.

Unter einer "Touch-Sensoreinheit" soll insbesondere eine elektronische Einheit verstanden werden, die elektrisch leitend mit einer ihr zugeordneten Elektrode verbunden ist und die dazu vorgesehen ist, die Elektrode elektrisch aufzuladen und eine, insbesondere durch eine Annäherung an die Elektrode und/oder durch eine Berührung der Elektrode hervorgerufene, Änderung eines von der Elektrode ausgehenden elektrischen Felds zu detektieren. Vorzugsweise ist die Touch-Sensoreinheit mit einer Steuer- und/oder Regeleinheit eines die Hausgerätebedienvorrichtung aufweisenden Hausgeräts verbunden und ist zu einer Eingabe von zumindest einem Steuerbefehl vorgesehen. Unter einem "Sensorbereich" der Elektrode soll in diesem Zusammenhang insbesondere ein zusammenhängender, insbesondere konvexer, Bereich der Elektrode verstanden werden, welcher insbesondere zu einer Annäherung und/oder einer Berührung insbesondere durch einen Bediener vorgesehen ist. Insbesondere können der erste und der zweite Sensorbereich Teil eines einzigen Touch-Bedienelements sein, welches insbesondere zumindest dazu vorgesehen ist, das Hausgerät, insbesondere zu einer Vermeidung einer unbefugten Benutzung, insbesondere durch Kinder, zu verriegeln und bei Bedarf zu entriegeln. Unter einem "Touch-Bedienelement" soll insbesondere ein Bedienelement verstanden werden, welches wenigstens eine Touch-Bedienoberfläche aufweist. Unter einer "Touch-Bedienoberfläche" soll insbesondere ein Oberflächenbereich verstanden werden, welcher ein berührungsempfindliches Bedienmittel bildet, welches durch Berühren, insbesondere auslenkungsfrei, betätigbar ist. Unter einem "Betätigen" eines Bedienmittels soll insbesondere ein Durchführen eines Bedienvorgangs oder eines Teils eines Bedienvorgangs mit Hilfe des Bedienmittels verstanden werden. Vorzugsweise weist die Touch-Bedienoberfläche wenigstens eine Markierung auf, durch welche die Sensorbereiche zumindest teilweise gekennzeichnet sind. Vorzugsweise sind die Sensorbereiche auf einer der Touch-Bedienoberfläche gegenüberliegenden Rückseite eines die Touch-Bedienoberfläche aufweisenden Elements angeordnet. Vorteilhaft sind die Sensorbereiche und die Touch-Sensoreinheit jeweils zumindest wesentlich beabstandet. Darunter, dass die Sensorbereiche und die Touch-Sensoreinheit jeweils "zumindest wesentlich beabstandet" sind, soll insbesondere verstanden werden, dass ein erster Abstand zwischen dem ersten Sensorbereich und der Touch-Sensoreinheit und ein zweiter Abstand zwischen dem zweiten Sensorbereich und der Touch-Sensoreinheit jeweils wenigstes 1 cm, insbesondere zumindest 2 cm, vorzugsweise mindestens 5 cm und besonders vorteilhaft wenigstens 10 cm beträgt.

Darunter, dass zwei Objekte "elektrisch leitend" verbunden sind, soll insbesondere verstanden werden, dass ein ohmscher Widerstand zwischen den Objekten bei 20°C höchstens 50 Ω, insbesondere maximal 10 Ω, vorzugsweise höchstens 5 Ω und besonders vorteilhaft maximal 1 Ω beträgt. Unter "vorgesehen" soll insbesondere speziell programmiert und/oder ausgelegt und/oder ausgestattet verstanden werden. Darunter, dass der erste und der zweite Sensorbereich dazu vorgesehen sind, die Touch-Sensoreinheit "lediglich bei einer gemeinsamen Annäherung und/oder Berührung durch einen Bediener auszulösen", soll insbesondere verstanden werden, dass die Sensorbereiche derart ausgebildet sind, dass eine Annäherung an lediglich einen der Sensorbereiche und/oder eine Berührung lediglich eines der Sensorbereiche eine Änderung des von der Elektrode ausgehenden elektrischen Felds bewirkt, welche von der Touch-Sensoreinheit unberücksichtigt bleibt, und dass eine gleichzeitige Annäherung an beide Sensorbereiche und/oder eine Berührung beider Sensorbereiche zu einer Änderung des von der Elektrode ausgehenden elektrischen Felds führt, welche von der Touch-Sensoreinheit als Betätigung berücksichtigt wird. Insbesondere können mehr als zwei Sensorbereiche vorgesehen sein, welche zu einer Auslösung der Touch-Sensoreinheit gleichzeitig zu betätigen sind. Hierbei ist insbesondere denkbar, dass drei Finger zu einem Auslösen der Touch-Sensoreinheit benötigt werden. Ferner ist insbesondere denkbar, dass viele, insbesondere weit beabstandete, Sensorbereiche gleichzeitig, insbesondere mit einer Handfläche, zu betätigen sind, um die Touch-Sensoreinheit auszulösen. Des Weiteren könnten die Touch-Sensoreinheit und/oder die Steuer- und/oder Regeleinheit des Hausgeräts insbesondere dazu vorgesehen sein, wenigstens eine bestimmte Folge von Betätigungsimpulsen zu erkennen und bei einer Registrierung dieser Folge von Betätigungsimpulsen zumindest eine Funktion des Hausgeräts zu aktivieren, vorzugsweise eine Verriegelung oder eine Entriegelung des Hausgeräts. Darunter, dass der Bereich "zwischen dem ersten Sensorbereich und dem zweiten Sensorbereich angeordnet ist", soll insbesondere verstanden werden, dass wenigstens eine Verbindungsstrecke von dem ersten Sensorbereich zu dem zweiten Sensorbereich existiert, welche den Bereich zumindest einmal schneidet. Unter einer "Verbindungsstrecke" von dem ersten Sensorbereich zu dem zweiten Sensorbereich soll in diesem Zusammenhang insbesondere eine Strecke verstanden werden, welche zumindest einen Punkt des ersten Sensorbereichs mit wenigstens einem Punkt des zweiten Sensorbereichs geradlinig verbindet.

Durch eine solche Ausgestaltung kann eine vorteilhafte Sicherung für Touch-Bedienelemente eines Hausgeräts, insbesondere eines Kochfelds, gegen eine unbefugte Benutzung erreicht werden. Insbesondere kann auf einen speziellen Bedieneingriff eines Bedieners, insbesondere zu einer Verriegelung oder Entriegelung des Hausgeräts, verzichtet werden. Andererseits kann für den Fall, dass eine Verriegelungsfunktion vorgesehen ist, eine vorteilhafte sichere Verriegelung geschaffen werden, die insbesondere von Kindern nur schwerlich betätigbar ist. Ferner kann eine komplexe Software und/oder Hardware zu einer Diskriminierung eines Erwachsenenfingers von einem Kinderfinger entfallen, wodurch Kosten gesenkt werden können. Des Weiteren kann eine flexibel gestaltbare Anordnung von Touch-Bedienoberflächen vorteilhaft mit einer Kindersicherung verbunden werden.

Vorteilhaft umfasst die Hausgerätebedienvorrichtung wenigstens eine Abschirmeinheit, welche zu einer Bereitstellung zumindest eines inaktiven Bereichs der Elektrode zumindest teilweise entlang der Elektrode angeordnet ist. Unter einer "Abschirmeinheit" soll insbesondere eine Einheit verstanden werden, welche dazu vorgesehen ist, zumindest eine wesentliche Beeinflussung eines von der Elektrode ausgehenden elektrischen Felds bei einer Annäherung an einen Bereich und/oder bei einer Berührung des Bereichs der Elektrode zu unterbinden und somit insbesondere einen inaktiven Bereich der Elektrode bereitzustellen. Unter einer "wesentlichen Beeinflussung" des von der Elektrode ausgehenden elektrischen Felds soll insbesondere eine Änderung des elektrischen Felds verstanden werden, die von der Touch-Sensoreinheit als ein auslösendes Ereignis erfasst wird. Die Annäherung an den Bereich und/oder die Berührung des Bereichs der Elektrode kann dabei von einem Bediener und/oder einem Kochgeschirr und/oder jedem beliebigen anderen Objekt erfolgen. Hierdurch kann eine sichere und zuverlässige Funktion erreicht werden. Insbesondere kann ein ungewolltes Auslösen der Touch-Sensoreinheit bei einer Annäherung an wenigstens einen außerhalb der Sensorbereiche liegenden Bereich der Elektrode und/oder bei einer Berührung des außerhalb der Sensorbereiche liegenden Bereichs der Elektrode vermieden werden.

Ferner wird vorgeschlagen, dass die Abschirmeinheit wenigstens ein mit einem Referenzpotentialanschluss elektrisch leitend verbundenes Leitelement aufweist. Unter einem "Referenzpotentialanschluss" soll insbesondere ein elektrischer Anschluss mit einem konstanten elektrischen Potential verstanden werden. Vorzugsweise ist der Referenzpotentialanschluss ein Erdungsanschluss, insbesondere ein Schutzerdungsanschluss und besonders vorteilhaft ein Funktionserdungsanschluss. Unter einem "Leitelement" soll insbesondere ein vorzugsweise zumindest teilweise metallisches Element verstanden werden, welches bei 20°C einen spezifischen elektrischen Widerstand von höchstens 10⁻⁴ Ωm, insbesondere von maximal 10⁻⁵ Ωm und vorteilhaft von höchstens 10⁻⁶ Ωm aufweist. Insbesondere kann das Leitelement aus dem gleichen Material wie die Elektrode bestehen. Vorzugsweise beträgt ein minimaler Abstand des Leitelements zur Elektrode wenigstens 0,1 mm, insbesondere mindestens 1 mm, vorzugsweise zumindest 2 mm und besonders vorteilhaft wenigstens 3 mm sowie insbesondere höchstens 5 mm und vorzugsweise maximal 4 mm. Vorzugsweise beträgt eine minimale Breite des Leitelements wenigstens 0,05 mm, insbesondere mindestens 0,1 mm, vorzugsweise zumindest 1 mm und besonders vorteilhaft wenigstens 2 mm sowie insbesondere höchstens 4 mm und vorzugsweise maximal 3 mm. Vorzugsweise ist das Leitelement in einem montierten Zustand an wenigstens einem eine Touch-Bedienoberfläche bereitstellenden Element angeordnet. Vorzugsweise ist das Leitelement als eine insbesondere zumindest teilweise metallische Beschichtung des Elements ausgebildet. Die Beschichtung kann dabei auf beliebige, dem Fachmann als sinnvoll erscheinende Art erfolgen, insbesondere durch Siebdruck elektrisch leitender Pasten und/oder durch Tintenstrahldruck und/oder chemische und/oder physikalische Gasphasenabscheidung, insbesondere Sputtern und insbesondere auch mit einer anschließenden Laserablation, bei welcher überflüssige Teile einer Beschichtung entfernt werden. Vorzugsweise beträgt eine Dicke, insbesondere eine Schichtdicke, des Leitelements mindestens 30 µm, insbesondere wenigstens 50 µm, vorteilhaft zumindest 70 µm und besonders vorteilhaft mindestens 90 µm. Vorzugsweise beträgt die Dicke, insbesondere die Schichtdicke, des Leitelements höchstens 200 µm, insbesondere maximal 170 µm, vorteilhaft höchstens 140 µm und besonders vorteilhaft maximal 110 µm. Hierdurch kann vorteilhaft eine besonders sichere und zuverlässige Funktion erreicht werden. In einer weiteren Ausgestaltung der Erfindung wird vorgeschlagen, dass der erste Sensorbereich und der zweite Sensorbereich als zwei Teilbereiche wenigstens eines ringförmigen Bereichs der Elektrode ausgebildet sind. Vorzugsweise ist der ringförmige Bereich kreisringförmig ausgebildet. Hierdurch kann ein hoher Bedienkomfort mit einer vorteilhaft einfachen Kindersicherung kombiniert werden.

Vorteilhaft beträgt ein Innendurchmesser des ringförmigen Bereichs zumindest 5 mm, insbesondere wenigstens 7,5 mm, vorzugsweise mindestens 10 mm, besonders vorteilhaft zumindest 12,5 mm und insbesondere höchstens 15 mm. Unter einem "Innendurchmesser" des ringförmigen Bereichs soll in diesem Zusammenhang insbesondere ein Durchmesser einer geometrischen Kugel maximalen Volumens verstanden werden, welche gerade noch durch eine innere Ausnehmung des ringförmigen Bereichs passt. Vorzugsweise beträgt ein Außendurchmesser des ringförmigen Bereichs zumindest 6 mm, insbesondere wenigstens 10 mm, besonders vorteilhaft mindestens 15 mm und insbesondere höchstens 20 mm. Unter einem "Außendurchmesser" des ringförmigen Bereichs soll in diesem Zusammenhang insbesondere ein Durchmesser einer geometrischen Kugel minimalen Volumens verstanden werden, welche den ringförmigen Bereich gerade noch umschließt. Hierdurch kann ein hoher Bedienkomfort beibehalten werden, da sich für einen Bediener eine gleichzeitige Betätigung der zwei Teilbereiche nicht von einer herkömmlichen Betätigung einer Touch-Bedienoberfläche unterscheidet. Dennoch kann vorteilhaft einfach eine integrierte Kindersicherung erreicht werden.

In einer bevorzugten Ausgestaltung der Erfindung wird vorgeschlagen, dass der erste Sensorbereich und der zweite Sensorbereich jeweils als zwei durch den inaktiven Bereich elektrisch leitend verbundene Teilbereiche der Elektrode ausgebildet sind. Vorzugsweise weist der inaktive Bereich der Elektrode eine minimale Breite von wenigstens 0,05 mm, insbesondere von mindestens 0,1 mm, vorzugsweise von zumindest 1 mm und besonders vorteilhaft von wenigstens 2 mm sowie insbesondere von höchstens 4 mm und vorzugsweise von maximal 3 mm auf. Hierdurch kann vorteilhaft eine hohe Sicherheit gegen eine unbefugte Aktivierung wenigstens einer Funktion des Hausgeräts erzielt werden.

In einer besonders bevorzugten Ausgestaltung der Erfindung wird vorgeschlagen, dass ein minimaler Abstand zwischen dem ersten Sensorbereich und dem zweiten Sensorbereich zumindest 5 cm, insbesondere wenigstens 10 cm, vorzugsweise mindestens 15 cm, vorteilhaft zumindest 20 cm und besonders vorteilhaft wenigstens 30 cm beträgt. Hierdurch kann vorteilhaft eine besonders hohe Sicherheit gegen eine unbefugte Aktivierung der Funktion des Hausgeräts erreicht werden, da ein Abstand der Sensorbereiche insbesondere so groß gewählt werden kann, dass ein Auslösen der Touch-Sensoreinheit durch Kochgeschirr und/oder Kinder unmöglich ist.

Ferner wird vorgeschlagen, dass die Hausgerätebedienvorrichtung wenigstens ein eine Touch-Bedienoberfläche bereitstellendes Element umfasst, an welcher die Elektrode in einem montierten Zustand angeordnet ist. Vorzugsweise besteht das Element zumindest teilweise aus einem elektrisch isolierenden Material. Unter einem "elektrisch isolierenden Material" soll insbesondere ein Material mit einem spezifischen elektrischen Widerstand von mindestens 10⁸ Ωm, insbesondere von wenigstens 10¹⁰ Ωm und vorteilhaft von zumindest 10¹² Ωm bei 20°C verstanden werden. Vorzugsweise sind die Elektrode und die Touch-Bedienoberflächen an verschiedenen, sich insbesondere gegenüberliegenden Oberflächen des Elements angeordnet. Vorzugsweise ist die Elektrode als eine Beschichtung des Elements ausgebildet. Die Beschichtung kann dabei auf beliebige, dem Fachmann als sinnvoll erscheinende Art erfolgen, insbesondere durch Siebdruck elektrisch leitender Pasten und/oder durch Tintenstrahldruck und/oder chemische und/oder physikalische Gasphasenabscheidung, insbesondere Sputtern und insbesondere auch mit einer anschließenden Laserablation, bei welcher überflüssige Teile einer Beschichtung entfernt werden. Insbesondere kann das Leitelement der Abschirmeinheit gleichzeitig mit der Elektrode auf das Element beschichtet werden. Vorzugsweise beträgt eine Dicke, insbesondere eine Schichtdicke, der Elektrode mindestens 30 µm, insbesondere wenigstens 50 µm, vorteilhaft zumindest 70 µm und besonders vorteilhaft mindestens 90 µm. Vorzugsweise beträgt die Dicke, insbesondere die Schichtdicke, der Elektrode höchstens 200 µm, insbesondere maximal 170 µm, vorteilhaft höchstens 140 µm und besonders vorteilhaft maximal 110 µm. Hierdurch kann eine einfache Konstruktion erreicht werden.

Vorteilhaft ist das Element Teil einer Kochfeldplatte. Unter einer "Kochfeldplatte" soll insbesondere ein Plattenelement verstanden werden, welches in einer Einbaulage horizontal angeordnet und zu einem Aufstellen von Gargeschirr zu Garzwecken vorgesehen ist. Vorzugsweise besteht die Kochfeldplatte zumindest im Wesentlichen, insbesondere mit einem Massenanteil von wenigsten 80 %, vorzugsweise von zumindest 90 % und besonders vorteilhaft von mindestens 95 %, aus einer Glaskeramik. Vorzugsweise stellt das Element zumindest einen Teil eines Bedienbereichs eines Kochfelds bereit. Hierdurch kann ein Bedienkomfort vorteilhaft gesteigert werden. Ferner kann ein Reinigungsaufwand reduziert werden.

Weitere Vorteile ergeben sich aus der folgenden Zeichnungsbeschreibung. In der Zeichnung sind zwei Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Kochfeld mit einer Kochfeldbedienvorrichtung in einer Draufsicht,
- Fig. 2: eine Kochfeldplatte der Kochfeldbedienvorrichtung aus Fig. 1 mit einer an der Kochfeldplatte angeordneten Elektrode und einer Abschirmeinheit in einer Ansicht von unten,
- Fig. 3: ein weiteres Kochfeld mit einer alternativen Kochfeldbedienvorrichtung in einer Draufsicht und
- Fig. 4: eine Kochfeldplatte der Kochfeldbedienvorrichtung aus Fig. 3 mit einer an der Kochfeldplatte angeordneten Elektrode und einer Abschirmeinheit in einer Ansicht von unten.

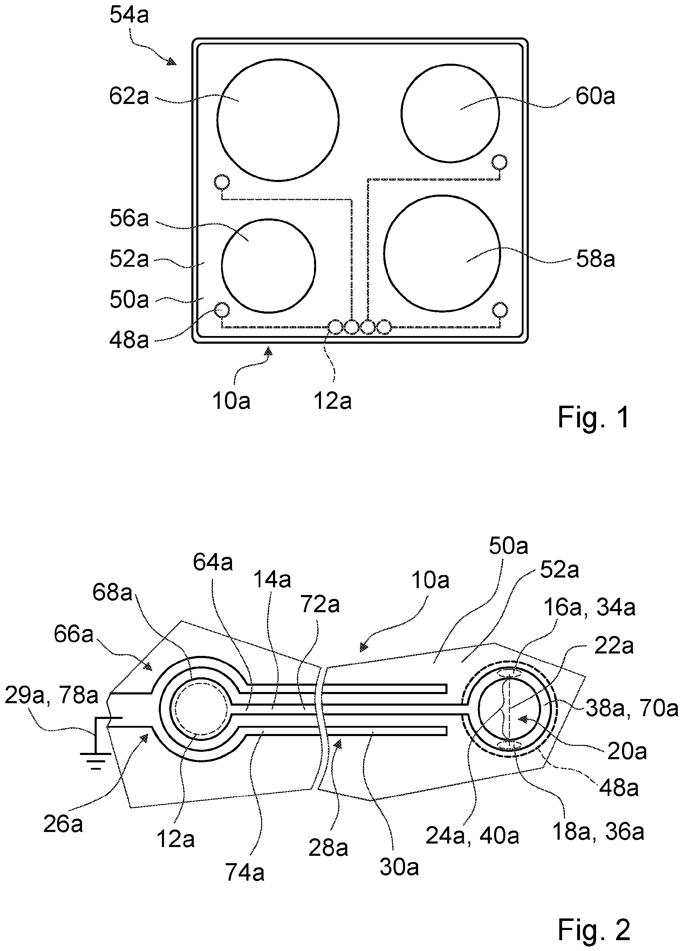

Figur 1 zeigt ein als Kochfeld 54a ausgebildetes Hausgerät mit einer als Kochfeldbedienvorrichtung 10a ausgestalteten Hausgerätebedienvorrichtung in einer Draufsicht. Die Kochfeldbedienvorrichtung 10a umfasst eine Kochfeldplatte 52a. Die Kochfeldplatte 52a besteht aus einem elektrisch isolierenden Material, vorzugsweise aus einer Glaskeramik. Die Kochfeldplatte 52a ist in einer Einbaulage horizontal angeordnet und zu einem Aufstellen von Gargeschirr zu Garzwecken vorgesehen. Auf der Kochfeldplatte 52a sind in bekannter Weise Heizzonen 56a, 58a, 60a, 62a markiert, wobei jeder der Heizzonen 56a, 58a, 60a, 62a eine unterhalb der Kochfeldplatte 52a angeordnete Heizeinheit zugeordnet ist. Jede Heizeinheit umfasst vorzugsweise zumindest ein Induktionsheizelement. Auf der Kochfeldplatte 52a sind ferner Touch-Bedienoberflächen 48a markiert, von denen in Figur 1 lediglich eine bezeichnet ist. Die Touch-Bedienoberflächen 48a sind jeweils räumlich einer der Heizzonen 56a, 58a, 60a, 62a zugeordnet und dazu vorgesehen, die betreffende Heizzone 56a, 58a, 60a, 62a durch Berührung mit einem Finger zu aktivieren bzw. zu deaktivieren. Jeder der Touch-Bedienoberflächen 48a ist eine Touch-Sensoreinheit 12a zugeordnet, welche unterhalb der Kochfeldplatte 52a angeordnet ist und, in einer zur Kochfeldplatte 52a parallelen Richtung betrachtet, von der Touch-Bedienoberfläche 48a beabstandet ist, und zwar insbesondere um zumindest 15 cm. Die Touch-Sensoreinheiten 12a sind dazu vorgesehen, eine Berührung der jeweiligen Touch-Bedienoberfläche 48a zu detektieren.

Figur 2 zeigt einen Teil der Kochfeldbedienvorrichtung 10a in einer Betrachtung der Kochfeldplatte 52a von unten. Jeder Touch-Bedienoberfläche 48a ist unter der Kochfeldplatte 52a eine Elektrode 14a zugeordnet. Bei der Elektrode 14a handelt es sich um eine elektrisch leitfähige Beschichtung 64a einer Unterseite 66a der Kochfeldplatte 52a. Die Elektrode 14a weist eine Dicke von 100 µm auf. Die Elektrode 14a umfasst einen Anlagebereich 68a für die Touch-Sensoreinheit 12a. Der Anlagebereich 68a ist im Wesentlichen kreisscheibenförmig ausgestaltet. Der Anlagebereich 68a weist einen Durchmesser von 10 mm auf. Die Elektrode 14a umfasst ferner einen Sensierbereich 70a, welcher unterhalb der Touch-Bedienoberfläche 48a angeordnet ist. Der Sensierbereich 70a ist im Wesentlichen kreisringscheibenförmig ausgebildet. Der Anlagebereich 68a und der Sensierbereich 70a sind durch einen Verbindungsbereich 72a miteinander elektrisch leitend verbunden. Der Verbindungsbereich 72a ist linienartig ausgebildet mit einer maximalen Breite von 1,5 mm. Der Anlagebereich 68a und der Verbindungsbereich 72a bilden einen inaktiven Bereich 28a, welcher durch eine Abschirmeinheit 26a abgeschirmt ist. Die Abschirmeinheit 26a umfasst ein Leitelement 30a, welches zumindest teilweise entlang des inaktiven Bereichs 28a angeordnet ist und diesen insbesondere zumindest teilweise umgreift. Das Leitelement 30a ist als eine elektrisch leitfähige Beschichtung 74a ausgebildet. Das Leitelement 30a weist eine Dicke von 100 µm auf. Ein minimaler Abstand zwischen dem Leitelement 30a und dem inaktiven Bereich 28a beträgt 2 mm. In Bereichen, in welchen das Leitelement 30a parallel zum Verbindungsbereich 72a verläuft, weist das Leitelement 30a auf beiden Seiten des Verbindungsbereichs 72a jeweils eine maximale Breite von 1,25 mm auf. Das Leitelement 30a ist mit einem Referenzpotentialanschluss 29a verbunden. Bei dem Referenzpotentialanschluss 29a handelt es sich um einen Erdungsanschluss 78a. Eine Umgebung des Sensierbereichs 70a ist frei von dem Leitelement 30a. Die Touch-Sensoreinheit 12a weist eine Kontaktstelle auf, die elektrisch leitend an dem Anlagebereich 68a anliegt. Die Touch-Sensoreinheit 12a umfasst ein elastisches Element (nicht dargestellt), welches in einem montierten Zustand eine elektrisch leitende Verbindung zwischen der Auswerteeinheit der Touch-Sensoreinheit 12a und dem Anlagebereich 68a herstellt.

In einem Betriebszustand wird in an sich bekannter Weise durch die Touch-Sensoreinheit 12a ein elektrisches Potential an die Elektrode 14a angelegt, wodurch in der Umgebung der Elektrode 14a ein elektrisches Feld entsteht. Im inaktiven Bereich 28a sind Feldlinien des elektrischen Felds zwischen der Elektrode 14a und dem Leitelement 30a konzentriert. Eine Berührung der Kochfeldplatte 52a durch einen Finger eines Bedieners in einem Bereich oberhalb des inaktiven Bereichs 28a führt daher lediglich zu einer vernachlässigbaren Beeinflussung des elektrischen Felds. Eine Berührung der Touch-Bedienoberfläche 48a, d.h. eines Bereichs der Kochfeldplatte 52a oberhalb des Sensierbereichs 70a, hingegen bewirkt eine durch die Touch-Sensoreinheit 12a nachweisbare Beeinflussung des elektrischen Felds in einer Umgebung des Sensierbereichs 70a, so dass eine Schaltfunktion realisierbar ist.

Der Sensierbereich 70a der Elektrode 14a ist zu einer Bereitstellung einer Kindersicherung als ringförmiger Bereich 38a ausgebildet. Der ringförmige Bereich 38a umfasst einen ersten Sensorbereich 16a und einen mit dem ersten Sensorbereich 16a elektrisch leitend verbundenen zweiten Sensorbereich 18a, welche derart beschaffen sind, dass sie die Touch-Sensoreinheit 12a lediglich dann auslösen, wenn ein erster Bereich der Touch-Bedienoberfläche 48a oberhalb des ersten Sensorbereichs 16a und ein zweiter Bereich der Touch-Bedienoberfläche 48a oberhalb des zweiten Sensorbereichs 18a gleichzeitig durch einen Bediener berührt werden. Zwischen den Sensorbereichen 16a, 18a ist ein von der Elektrode 14a verschieden ausgebildeter Bereich 20a angeordnet, welcher entlang wenigstens einer Verbindungsstrecke 22a von dem ersten Sensorbereich 16a zu dem zweiten Sensorbereich 18a eine Erstreckung 24a von zumindest 13 mm aufweist. Die Erstreckung 24a entspricht einem Innendurchmesser 40a des ringförmigen Bereichs 38a. Der Innendurchmesser 40a ist derart gewählt, dass lediglich ein Finger, dessen Druckfläche zumindest der Druckfläche eines durchschnittlichen Erwachsenenfingers entspricht, eine Beeinflussung des elektrischen Felds in der Umgebung des ringförmigen Bereichs 38a nach sich zieht, die zu einer Auslösung der Touch-Sensoreinheit 12a führt. Eine durchschnittliche Druckfläche eines Kinderfingers ist nicht in der Lage, eine ausreichend große Fläche des ringförmigen Bereichs 38a abzudecken. Eine Beeinflussung des elektrischen Felds in der Umgebung des ringförmigen Bereichs 38a fällt in diesem Fall schlichtweg zu klein aus, als dass sie zu einer Auslösung der Touch-Sensoreinheit 12a führen könnte. Eine Aktivierung der der Touch-Bedienoberfläche 48a zugeordneten Heizzone 56a durch einen Kinderfinger kann somit vermieden werden.

Um eine sichere Funktion zu gewährleisten, können geometrische Maße der Elektrode 14a und/oder des Leitelements 30a, insbesondere Dicken und/oder Breiten und/oder Durchmesser, und/oder der minimale Abstand zwischen der Elektrode 14a von dem Leitelement 30a an eine gegebene Sensitivität der Touch-Sensoreinheit 12a angepasst werden. Insbesondere kann dadurch sichergestellt werden, dass sich für alle Touch-Bedienoberflächen 48a der Kochfeldbedienvorrichtung 10a die gleiche oder zumindest eine ähnliche Sensitivität ergibt.

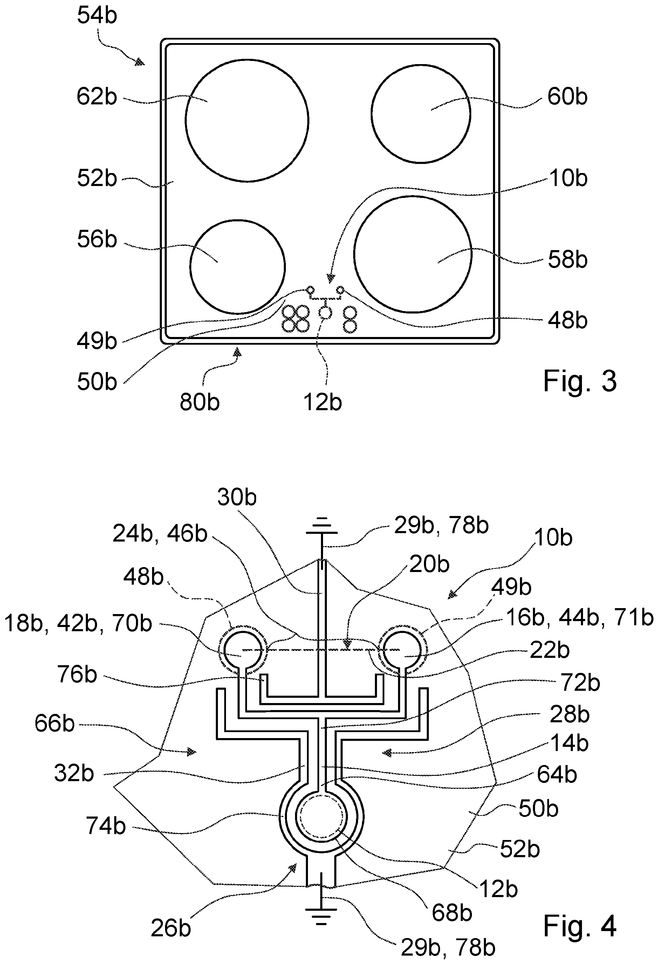

Bei der Ausgestaltung gemäß den Figuren 1 und 2 wäre jedoch nach wie vor ein Auslösen der Touch-Sensoreinheit 12a durch ein Kind mittels eines Auflegens einer flachen Hand oder zweier Finger denkbar. In den Figuren 3 und 4 wird ein weiteres Ausführungsbeispiel der Erfindung gezeigt, durch welches auch diese Gefahr minimiert werden kann. Die nachfolgenden Beschreibungen beschränken sich im Wesentlichen auf die Unterschiede zwischen den Ausführungsbeispielen, wobei bezüglich gleich bleibender Bauteile, Merkmale und Funktionen auf die Beschreibung des Ausführungsbeispiels der Figuren 1 und 2 verwiesen werden kann. Zur Unterscheidung der Ausführungsbeispiele ist der Buchstabe a in den Bezugszeichen des Ausführungsbeispiels in den Figuren 1 und 2 durch den Buchstaben b in den Bezugszeichen des Ausführungsbeispiels der Figuren 3 und 4 ersetzt. Bezüglich gleich bezeichneter Bauteile, insbesondere in Bezug auf Bauteile mit gleichen Bezugszeichen, kann grundsätzlich auch auf die Zeichnungen und/oder die Beschreibung des Ausführungsbeispiels der Figuren 1 und 2 verwiesen werden.

Figur 3 zeigt ein Kochfeld 54b mit einer Kochfeldbedienvorrichtung 10b in einer Draufsicht. Die Kochfeldbedienvorrichtung 10b umfasst eine Kochfeldplatte 52b auf welcher mehrere Touch-Bedienoberflächen 48b, 49b markiert sind, von denen in Figur 3 lediglich zwei bezeichnet sind. Sämtliche Touch-Bedienoberflächen 48b, 49b sind in einem Bedienbereich 80b der Kochfeldplatte 52b angeordnet. Der Bedienbereich 80b ist mittig an einer vorderen, einem Bediener zugewandten Kante der Kochfeldplatte 52b angeordnet. Das Kochfeld 54b umfasst eine Verriegelung, welche durch eine gleichzeitige Betätigung zweier Touch-Bedienoberflächen 48b, 49b betätigbar ist. In einem verriegelten Zustand des Kochfelds 54b sind sämtliche Bedienelemente des Kochfelds 54b gegen eine unbefugte Benutzung gesperrt. In einem entriegelten Zustand des Kochfelds 54b ist eine normale Benutzung der Bedienelemente des Kochfelds 54b möglich. Durch eine gleichzeitige Berührung der beiden Touch-Bedienoberflächen 48b, 49b durch einen Bediener kann das Kochfeld 54b verriegelt bzw. entriegelt werden. Um eine Entriegelung durch ein Kind zumindest weitgehend auszuschließen, weisen die Touch-Bedienoberflächen 48b, 49b einen Abstand von zumindest 10 cm auf. Den Touch-Bedienoberflächen 48b, 49b ist eine Touch-Sensoreinheit 12b zugeordnet, welche unterhalb der Kochfeldplatte 52b angeordnet ist und, in einer zur Kochfeldplatte 52b parallelen Richtung betrachtet, von den Touch-Bedienoberflächen 48b, 49b jeweils beabstandet ist, und zwar insbesondere jeweils um zumindest 10 cm. Die Touch-Sensoreinheit 12b ist dazu vorgesehen, eine gemeinsame Berührung der Touch-Bedienoberfläche 48b, 49b zu detektieren.

Figur 4 zeigt einen Teil der Kochfeldbedienvorrichtung 10b in einer Betrachtung der Kochfeldplatte 52b von unten. Den Touch-Bedienoberflächen 48b, 49b ist unter der Kochfeldplatte 52b eine Elektrode 14b zugeordnet. Bei der Elektrode 14b handelt es sich um eine elektrisch leitfähige Beschichtung 64b einer Unterseite 66b der Kochfeldplatte 52b. Die Elektrode 14b weist eine Dicke von 100 µm auf. Die Elektrode 14b umfasst einen Anlagebereich 68b für die Touch-Sensoreinheit 12b. Der Anlagebereich 68b ist im Wesentlichen kreisscheibenförmig ausgestaltet. Der Anlagebereich 68b weist einen Durchmesser von 10 mm auf. Die Elektrode 14b umfasst ferner zwei Sensierbereiche 70b, 71 b, welche jeweils unterhalb einer der Touch-Bedienoberflächen 48b, 49b angeordnet sind. Die Sensierbereiche 70b, 71 b sind jeweils im Wesentlichen kreisscheibenförmig ausgebildet. Der Anlagebereich 68b und die Sensierbereiche 70b, 71 b sind durch einen Verbindungsbereich 72b miteinander elektrisch leitend verbunden. Der Verbindungsbereich 72b ist linienartig ausgebildet mit einer maximalen Breite von 1,5 mm. Der Anlagebereich 68b und der Verbindungsbereich 72b bilden einen inaktiven Bereich 28b, welcher durch eine Abschirmeinheit 26b abgeschirmt ist. Die Abschirmeinheit 26b umfasst zwei Leitelemente 30b, 32b, welche jeweils zumindest teilweise entlang des inaktiven Bereichs 28b angeordnet sind und diesen insbesondere zumindest teilweise umgreifen. Die Leitelemente 30b, 32b sind jeweils als elektrisch leitfähige Beschichtungen 74b, 76b ausgebildet. Die Leitelemente 30b, 32b weisen jeweils eine Dicke von 100 µm auf. Ein minimaler Abstand zwischen den Leitelementen 30b, 32b und dem inaktiven Bereich 28b beträgt jeweils 2 mm. Die Leitelemente 30b, 32b weisen in Bereichen, in welchen sie parallel zum Verbindungsbereich 72b verlaufen, eine maximale Breite von 1,25 mm auf. Die Leitelemente 30b, 32b sind jeweils mit einem Referenzpotentialanschluss 29b verbunden. Bei dem Referenzpotentialanschluss 29b handelt es sich um einen Erdungsanschluss 78b. Eine Umgebung der Sensierbereiche 70b, 71 b ist frei von den Leitelementen 30b, 32b. Die Touch-Sensoreinheit 12b weist eine Kontaktstelle auf, die elektrisch leitend an dem Anlagebereich 68b anliegt. Die Touch-Sensoreinheit 12b umfasst ein elastisches Element (nicht dargestellt), welches in einem montierten Zustand eine elektrisch leitende Verbindung zwischen der Auswerteeinheit der Touch-Sensoreinheit 12b und dem Anlagebereich 68b herstellt.

Der Sensierbereich 70b bildet einen ersten Sensorbereich 16b der Elektrode 14b. Der Sensierbereich 71 b bildet einen zweiten Sensorbereich 18b der Elektrode 14b, welcher elektrisch leitend mit dem ersten Sensorbereich 16b verbunden ist. Die Sensorbereiche 16b, 18b sind derart ausgebildet, dass sie die Touch-Sensoreinheit 12b lediglich dann auslösen, wenn die oberhalb des ersten Sensorbereichs 16b angeordnete Touch-Bedienoberfläche 49b und die oberhalb des zweiten Sensorbereichs 18b angeordnete Touch-Bedienoberfläche 48b gleichzeitig durch einen Bediener berührt werden. Bei Berührung lediglich eines der Touch-Bedienoberflächen 48b, 49b ist eine Beeinflussung eines elektrischen Felds in einer Umgebung des entsprechenden Sensorbereichs 16b, 18b für ein Auslösen der Touch-Sensoreinheit 12b zu klein. Zwischen dem ersten Sensorbereich 16b und dem zweiten Sensorbereich 18b ist ein von der Elektrode 14b verschieden ausgebildeter Bereich 20b angeordnet, welcher entlang wenigstens einer Verbindungsstrecke 22b von dem ersten Sensorbereich 16b zu dem zweiten Sensorbereich 18b eine Erstreckung 24b von zumindest 10 cm aufweist. Der erste Sensorbereich 16b und der zweite Sensorbereich 18b sind als zwei durch den inaktiven Bereich 28b elektrisch leitend verbundene Teilbereiche 42b, 44b der Elektrode 14b ausgebildet.

Um eine sichere Funktion zu gewährleisten, können geometrische Maße der Elektrode 14b und/oder der Leitelemente 30b, 32b, insbesondere Dicken und/oder Breiten und/oder Durchmesser, und/oder der minimale Abstand zwischen der Elektrode 14b von den Leitelementen 30b, 32b an eine gegebene Sensitivität der Touch-Sensoreinheit 12b angepasst werden. Für sämtliche Touch-Bedienoberflächen 48b, 49b der Kochfeldbedienvorrichtung 10b werden zueinander identische Touch-Sensoreinheiten 12b verwendet. Demzufolge müssen die Teilbereiche 42b, 44b derart ausgebildet sein, dass sie bei einer gemeinsamen Betätigung eine vergleichbare Beeinflussung eines elektrischen Felds bewirken wie ein entsprechender Sensierbereich einer konventionellen Touch-Bedienoberfläche.

In alternativen Ausgestaltungen kann ein deutlich größerer Abstand zwischen Teilbereichen einer Elektrode vorgesehen sein. Insbesondere können die Teilbereiche jeweils in einer Umgebung von sich gegenüberliegenden Kanten einer Kochfeldplatte angeordnet sein, so dass ein besonders großer Abstand erreicht werden kann. Ferner können mehr als zwei Teilbereiche vorgesehen sein, welche einer gleichzeitigen Betätigung bedürfen, um eine Touch-Sensoreinheit auszulösen. Des Weiteren ist denkbar, dass gleichzeitig zu betätigende Touch-Bedienoberflächen anstatt zu einer Verriegelung eines gesamten Kochfelds für eine unmittelbare Aktivierung einer einzelnen Heizzone des Kochfelds vorgesehen sind.

**Bezugszeichen**

| | | | |
|---|---|---|---|
| 10 | Kochfeldbedienvorrichtung | 58 | Heizzone |
| 12 | Touch-Sensoreinheit | 60 | Heizzone |
| 14 | Elektrode | 62 | Heizzone |
| 16 | Erster Sensorbereich | 64 | Beschichtung |
| 18 | Zweiter Sensorbereich | 66 | Unterseite |
| 20 | Bereich | 68 | Anlagebereich |
| 22 | Verbindungsstrecke | 70 | Sensierbereich |
| 24 | Erstreckung | 71 | Sensierbereich |
| 26 | Abschirmeinheit | 72 | Verbindungsbereich |
| 28 | Inaktiver Bereich | 74 | Beschichtung |
| 29 | Referenzpotentialanschluss | 76 | Beschichtung |
| 30 | Leitelement | 78 | Erdungsanschluss |
| 32 | Leitelement | 80 | Bedienbereich |
| 34 | Teilbereich | | |
| 36 | Teilbereich | | |
| 38 | Ringförmiger Bereich | | |
| 40 | Innendurchmesser | | |
| 42 | Teilbereich | | |
| 44 | Teilbereich | | |
| 46 | Minimaler Abstand | | |
| 48 | Touch-Bedienoberfläche | | |
| 49 | Touch-Bedienoberfläche | | |
| 50 | Element | | |
| 52 | Kochfeldplatte | | |
| 54 | Kochfeld | | |
| 56 | Heizzone | | |

## Patentansprüche

1. Hausgerätebedienvorrichtung, insbesondere Kochfeldbedienvorrichtung (10a; 10b), mit wenigstens einer Touch-Sensoreinheit (12a; 12b), mit zumindest einer der Touch-Sensoreinheit (12a; 12b) zugeordneten Elektrode (14a; 14b), wobei die Elektrode (14a, 14b) zumindest einen ersten Sensorbereich (16a; 16b) und zumindest einen elektrisch leitend mit dem ersten Sensorbereich (16a; 16b) verbundenen zweiten Sensorbereich (18a; 18b) umfasst, und mit wenigstens einem von der Elektrode (14a; 14b) verschieden ausgebildeten Bereich (20a; 20b), welcher zwischen dem ersten Sensorbereich (16a; 16b) und dem zweiten Sensorbereich (18a; 18b) angeordnet ist, **dadurch gekennzeichnet, dass** der erste Sensorbereich (16a; 16b) und der zweite Sensorbereich (18a; 18b) dazu vorgesehen sind, die Touch-Sensoreinheit (12a; 12b) lediglich bei einer gemeinsamen Annäherung und/oder Berührung durch einen Bediener auszulösen und der Bereich (20a; 20b) entlang wenigstens einer Verbindungsstrecke (22a; 22b) von dem ersten Sensorbereich (16a; 16b) zu dem zweiten Sensorbereich (18a; 18b) eine Erstreckung (24a; 24b) von zumindest 5 mm aufweist.

2. Hausgerätebedienvorrichtung nach Anspruch 1, **gekennzeichnet durch** wenigstens eine Abschirmeinheit (26a; 26b), welche zu einer Bereitstellung zumindest eines inaktiven Bereichs (28a; 28b) der Elektrode (14a; 14b) zumindest teilweise entlang der Elektrode (14a; 14b) angeordnet ist.

3. Hausgerätebedienvorrichtung nach Anspruch 2, **dadurch gekennzeichnet, dass** die Abschirmeinheit (26a; 26b) wenigstens ein mit einem Referenzpotentialanschluss (29a; 29b) elektrisch leitend verbundenes Leitelement (30a; 30b, 32b) aufweist.

4. Hausgerätebedienvorrichtung nach einem der vorhergehenden Ansprüche, **dadurch gekennzeichnet, dass** der erste Sensorbereich (16a) und der zweite Sensorbereich (18a) als zwei Teilbereiche (34a, 36a) wenigstens eines ringförmigen Bereichs (38a) der Elektrode (14a) ausgebildet sind.

5. Hausgerätebedienvorrichtung nach Anspruch 4, **dadurch gekennzeichnet, dass** ein Innendurchmesser (40a) des ringförmigen Bereichs (38a) zumindest 5 mm und höchstens 15 mm beträgt.

6. Hausgerätebedienvorrichtung zumindest nach Anspruch 2, **dadurch gekennzeichnet, dass** der erste Sensorbereich (16b) und der zweite Sensorbereich (18b) jeweils als zwei durch den inaktiven Bereich (28b) elektrisch leitend verbundene Teilbereiche (42b, 44b) der Elektrode (14b) ausgebildet sind.

7. Hausgerätebedienvorrichtung nach Anspruch 6, **dadurch gekennzeichnet, dass** ein minimaler Abstand (46b) zwischen dem ersten Sensorbereich (16b) und dem zweiten Sensorbereich (18b) zumindest 5 cm beträgt.

8. Hausgerätebedienvorrichtung nach einem der vorhergehenden Ansprüche, **gekennzeichnet durch** wenigstens ein eine Touch-Bedienoberfläche (48a; 48b, 49b) bereitstellendes Element (50a; 50b), an welcher die Elektrode (14a; 14b) in einem montierten Zustand angeordnet ist.

9. Hausgerätebedienvorrichtung nach Anspruch 8, **dadurch gekennzeichnet, dass** das Element (50a; 50b) Teil einer Kochfeldplatte (52a; 52b) ist.

10. Hausgerät, insbesondere Kochfeld (54a; 54b), mit einer Hausgerätebedienvorrichtung nach einem der vorhergehenden Ansprüche.

## Claims

1. Household appliance operating device, in particular hob operating device (10a; 10b), having at least one touch sensor unit (12a; 12b), having at least one electrode (14a; 14b) allocated to the touch sensor unit (12a; 12b), wherein the electrode (14a; 14b) comprises at least one first sensor region (16a; 16b) and at least one electrically conductive second sensor region (18a; 18b) connected to the first sensor region (16a; 16b), and having at least one region (20a; 20b) formed differently from the electrode (14a; 14b) and arranged between the first sensor region (16a; 16b) and the second sensor region (18a; 18b), **characterised in that** the first sensor region (16a; 16b) and the second sensor region (18a; 18b) are provided to trigger the touch sensor unit (12a; 12b) only when they are jointly approached and/or touched by an operator, and the region (20a; 20b) has, along at least one connection length (22a; 22b) from the first sensor region (16a; 16b) to the second sensor region (18a; 18b), an extension (24a; 24b) of at least 5 mm.

2. Household appliance operating device according to claim 1, **characterised by** at least one shielding unit (26a; 26b), which to provide at least one inactive region (28a; 28b) of the electrode (14a; 14b) is arranged at least partially along the electrode (14a; 14b).

3. Household appliance operating device according to claim 2, **characterised in that** the shielding unit (26a; 26b) has at least one conductive element (30a; 30b, 32b) electrically conductively connected to a reference potential terminal (29a; 29b).

4. Household appliance operating device according to one of the preceding claims, **characterised in that** the first sensor region (16a) and the second sensor region (18a) are embodied as two subregions (34a, 36a) of at least one annular region (38a) of the electrode (14a).

5. Household appliance operating device according to claim 4, **characterised in that** an internal diameter (40a) of the annular region (38a) is at least 5 mm and a maximum of 15 mm.

6. Household appliance operating device at least according to claim 2, **characterised in that** the first sensor region (16b) and the second sensor region (18b) are each embodied as two subregions (42b, 44b) of the electrode (14b) electrically conductively connected by the inactive region (28b).

7. Household appliance operating device according to claim 6, **characterised in that** a minimum distance (46b) between the first sensor region (16b) and the second sensor region (18b) is at least 5 cm.

8. Household appliance operating device according to one of the preceding claims, **characterised by** at least one element (50a; 50b) providing a touch operating interface (48a; 48b, 49b), the electrode (14a; 14b) being arranged in a mounted state on said element (50a; 50b).

9. Household appliance operating device according to claim 8, **characterised in that** the element (50a; 50b) is part of a hob plate (52a; 52b).

10. Household appliance, in particular hob (54a; 54b), having a household appliance operating device according to one of the preceding claims.

## Revendications

1. Dispositif de commande d'appareil ménager, notamment dispositif de commande de plaque de cuisson (10a ; 10b), comprenant au moins une unité de capteur tactile (12a ; 12b), comprenant au moins une électrode (14a ; 14b) attribuée à l'unité de capteur tactile (12a ; 12b), l'électrode (14a, 14b) comprenant au moins une première zone de détection (16a ; 16b) et au moins une deuxième zone de détection (18a ; 18b) reliée de manière électro-conductrice à la première zone de détection (16a ; 16b), et comprenant au moins une zone (20a ; 20b) réalisée de manière différente de l'électrode (14a ; 14b), laquelle zone est disposée entre la première zone de détection (16a ; 16b) et la deuxième zone de détection (18a ; 18b), **caractérisé en ce que** la première zone de détection (16a ; 16b) et la deuxième zone de détection (18a ; 18b) sont ménagées pour déclencher l'unité de capteur tactile (12a ; 12b) uniquement lors d'une approche commune et/ou d'un contact commun par un utilisateur, et **en ce que** la zone (20a ; 20b) présente une étendue (24a ; 24b) d'au moins 5 mm le long d'au moins un trajet de liaison (22a ; 22b) allant de la première zone de détection (16a ; 16b) vers la deuxième zone de détection (18a ; 18b).

2. Dispositif de commande d'appareil ménager selon la revendication 1, **caractérisé par** au moins une unité de blindage (26a ; 26b), laquelle est disposée au moins en partie le long de l'électrode (14a ; 14b) pour une mise à disposition au moins d'une zone inactive (28a ; 28b) de l'électrode (14a ; 14b).

3. Dispositif de commande d'appareil ménager selon la revendication 2, **caractérisé en ce que** l'unité de blindage (26a ; 26b) présente au moins un élément conducteur (30a ; 30b, 32b) relié de manière électroconductrice à un raccord de potentiel de référence (29a ; 29b).

4. Dispositif de commande d'appareil ménager selon l'une quelconque des revendications précédentes, **caractérisé en ce que** la première zone de détection (16a) et la deuxième zone de détection (18a) sont réalisées en tant que deux zones partielles (34a ; 36a) d'au moins une zone annulaire (38a) de l'électrode (14a).

5. Dispositif de commande d'appareil ménager selon la revendication 4, **caractérisé en ce qu'**un diamètre intérieur (40a) de la zone annulaire (38a) est au moins de 5 mm et au maximum de 15 mm.

6. Dispositif de commande d'appareil ménager au moins selon la revendication 2, **caractérisé en ce que** la première zone de détection (16b) et la deuxième zone de détection (18b) sont respectivement réalisées en tant que deux zones partielles (42b ; 44b) de l'électrode (14b), reliées de manière électroconductrice par la zone inactive (28b).

7. Dispositif de commande d'appareil ménager au moins selon la revendication 6, **caractérisé en ce qu'**un écart minimal (46b) entre la première zone de détection (16b) et la deuxième zone de détection (18b) est d'au moins 5 cm.

8. Dispositif de commande d'appareil ménager selon l'une quelconque des revendications précédentes, **caractérisé par** au moins un élément (50a ; 50b) fournissant une surface de commande tactile (48a ; 48b, 49b), sur laquelle est disposée l'électrode (14a ; 14b) dans un état monté.

9. Dispositif de commande d'appareil ménager selon la revendication 8, **caractérisé en ce que** l'élément (50a ; 50b) fait partie d'une plaque de cuisson (52a ; 52b).

10. Appareil ménager, notamment plaque de cuisson (54a ; 54b) comprenant un dispositif de commande d'appareil ménager selon l'une quelconque des revendications précédentes.
